# EUROPEAN PATENT SPECIFICATION

(11) **EP 1 627 468 B1**
(45) Date of publication and mention of the grant of the patent: **20.02.2008**
(21) Application number: 04732349.8
(22) Date of filing: 12.05.2004
(51) Int. Cl.: H03K 17/687

(54) **IMPROVEMENTS TO RESONANT LINE DRIVERS**
VERBESSERUNGEN AN RESONANZ-LEITUNGSTREIBERN
AMELIORATIONS APPORTEES A DES CIRCUITS D'ATTAQUE DE LIGNE RESONNANTS

(30) Priority: 12.05.2003 GB 0310844
(43) Date of publication of application: 22.02.2006
(73) Proprietor: MIDAS GREEN LIMITED, Dry Drayton, Cambridgeshire CB3 8AR (GB)
(72) Inventor: HARVEY, Geoffrey, Philip, Midas Green Limited, Cambridge CB3 8AR (GB)
(74) Representative: Dunlop, Hugh Christopher
(86) International application number: PCT/GB2004/002026
(87) International publication number: WO 2004/100375

(56) References cited:
- US-A- 6 140 848

## Description

### Field of the Invention

This invention relates to electronic circuits. In particular this invention relates to improving the performance of a type of electronic driver circuit the operation of which is intended to reduce power consumption. This invention relates to achieving low power consumption in such driver circuits, whilst at the same time producing desirable signal characteristics.

### Background to the Invention

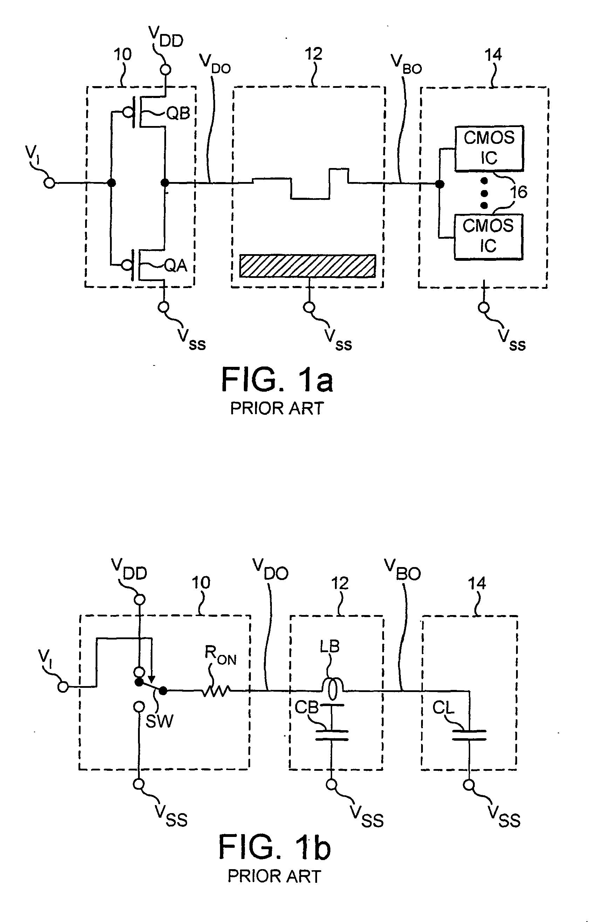

For many years conventional driver circuits have existed which communicate a logic value from one part of a system to another by representing each of two logic values respectively by one of two voltage levels. For example Fig. 1a shows a conventional CMOS inverting driver 10 formed as part of an IC. Output driver 10 generates an inverted driver output voltage VDO in response to a driver input voltage signal VI. Driver 10 is connected through electrical conductor 12 printed wiring board (PWB) to load circuitry 14. Specifically, electrical conductor 12 converts driver output voltage VDO into conductor output voltage VBO that drives a group of one or more digital ICs 16 in load 14.

Driver 10 is formed with N-channel insulated gate field effect transistor ('FET') QA and P-channel insulated gate FET QB whose gate electrodes receive driver input voltage VI. The sources of FET QA and QB respectively are connected to a source of low supply voltage VSS, typically ground reference (0 volts) and a source high supply voltage VDD. The QA and QB drains are connected together to provide driver output voltage VDO. N-channel FET QA is turned on by raising input voltage VI to suitably high level. On the other hand FET QB is turned on by reducing input voltage VI to a suitably low level.

Accordingly, only one of FETs QA and QB is conductive during steady state operation. If input VI is high, FET QA is turned on to pull driver output voltage VDO to a low value close to VSS. Conversely, output voltage VDO is at a high value close to VDD when input voltage VI is low and causes FET QB to be turned on. The "on" resistance of each of FET QA and QB is normally quite low. Consequently output signal VDO makes a rapid transition from VSS to VDD in response to a rapid transition of input signal VI from high to low. Likewise output signal VDO makes a rapid transition from VDD to VSS in response to a rapid transition of input signal VI from low to high. During a transition there is a typically a brief period when both FETs QA and QB are conductive.

PWB electrical conductor 12, commonly referred to as an interconnect, consists of copper track and a ground plane at the VSS potential. The steps shown in the line passing through conductor 12 in Fig. 1a qualitatively represent the changes in direction that conductor 12 makes on the PWB. The ground plane is represented by the block slanted shading.

Since Fig. 1b is a simplified electrical model, it does not show the parasitic lead inductances which typically exist when driver 10 is formed as part of an integrated circuit which is contained within an in integrated circuit package which is in turn mounted on a PWB. These parasitic inductances must be accounted for in the design of driver 10 if an undesirable effect known as ground/power bounce is to be avoided.

Interconnect 12 in Fig. 1a or 1b having distributed inductance and capacitance is alternatively known as a transmission line having characteristic impedance Z0. As is well known in the art, RON in Fig. 1b is ideally chosen to match Z0 so that a half amplitude outward bound wave is launched initially which doubles its amplitude on reaching load 14 and reflects back towards driver 10 as a full amplitude wave. In the absence of RON or if RON is too small, the reflected wave is of an amplitude exceeding the level of VDD and causing signal integrity problems.

In his previous application (PCT/GB96/02199, US6,201,420B1, EP0848868 etc), applicant describes a method by which, rather than generating a half amplitude outward bound wave by effectively by dropping voltage through a resistance RON, an equivalent wave can be launched by connecting signal VDO via a low "ON" resistance switch or transistor to an intermediate voltage VHH generated from an additional voltage supply or simply from a reservoir capacitor. The method has the advantage that less power is dissipated and the power consumption can be reduced by up to 75%. The technique is equally applicable to situations in which load capacitance CL is much larger than distributed capacitance CB in which case CL and LB act more like a sinusoidally LC resonant system than a transmission line. For ease of reference a driver employing the method will be referred to as a resonant line driver.

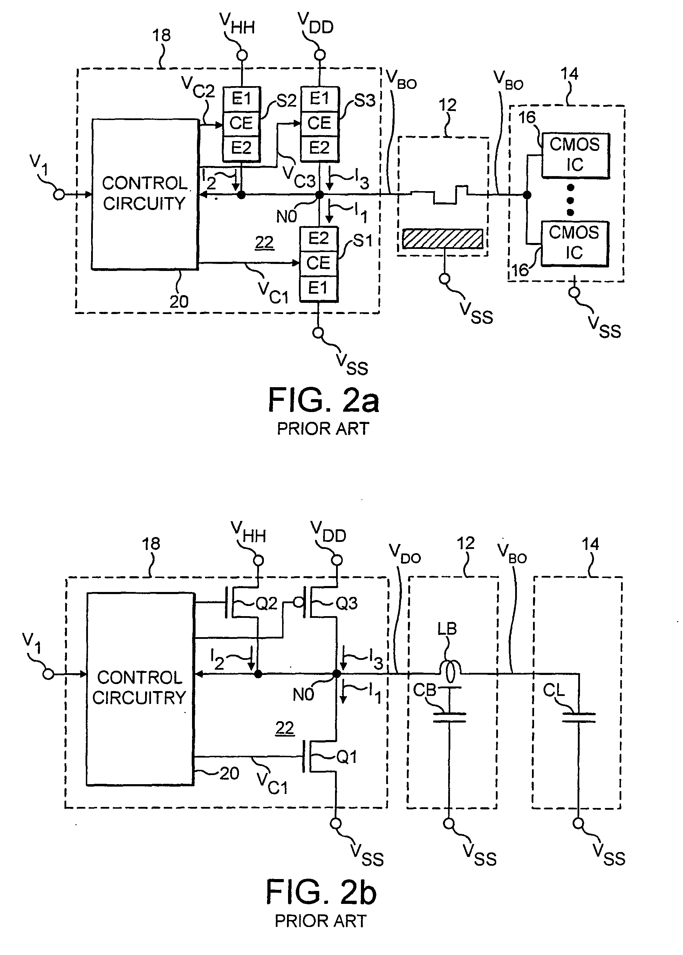

Figs. 2a and 2b show how the resonant line driver can equivalently replace conventional line driver of Figs 1a and 1b.

Fig. 2b for example shows a CMOS implementation of a resonant line driver. Q1 and Q3 can connect the driver output VDO to low and high voltage sources VSS and VDD respectively as in a conventional driver. Particular to the resonant line driver, Q2 can connect driver output VDO also to an intermediate voltage source VHH during transitions. Gate electrodes (and therefore switching of Q1, Q2 & Q3) are controlled by control circuit 20 via signals VC1, VC2 & VC3 respectively. Since Q1 and Q3 are N channel MOSFET (NMOS) transistors, they provide a conductive path when VC1 and VC3 respective are at a high voltage level. Since Q2 is a P channel MOSFETs (PMOS) transistor it provides a conductive path when VC2 respective is at a low voltage level.

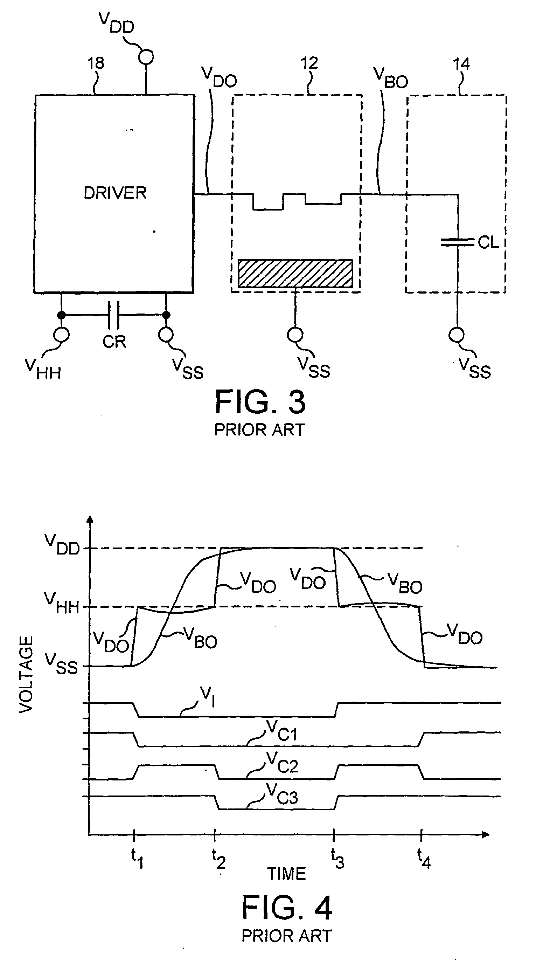

Fig. 3 shows that intermediate voltage supply VHH can be supplied by a reservoir capacitor CR.

Fig. 4 shows waveforms representative of the operation of the circuit shown in Fig. 2b when CL is much larger than CB and CL and LB act more like a sinusoidally LC resonant system than a transmission line. Initially only Q1 is "ON" and VDO is at a low level. Then in response to a change of level of the input signal VI at time t1 Q1 is switched "OFF" while Q2 is switched "ON" driving VDO near to the level of VHH. Current builds sinusoidally to a maximum and then falls back to zero whilst at the same time the voltage seen at the load VBO swings sinusoidally to the level of VDD at which point control circuit 20 switches Q2 "OFF" and switches Q3 "ON" to complete the transition. As shown in Fig. 4, the circuit operates in a similar manner to produce the opposite polarity transition

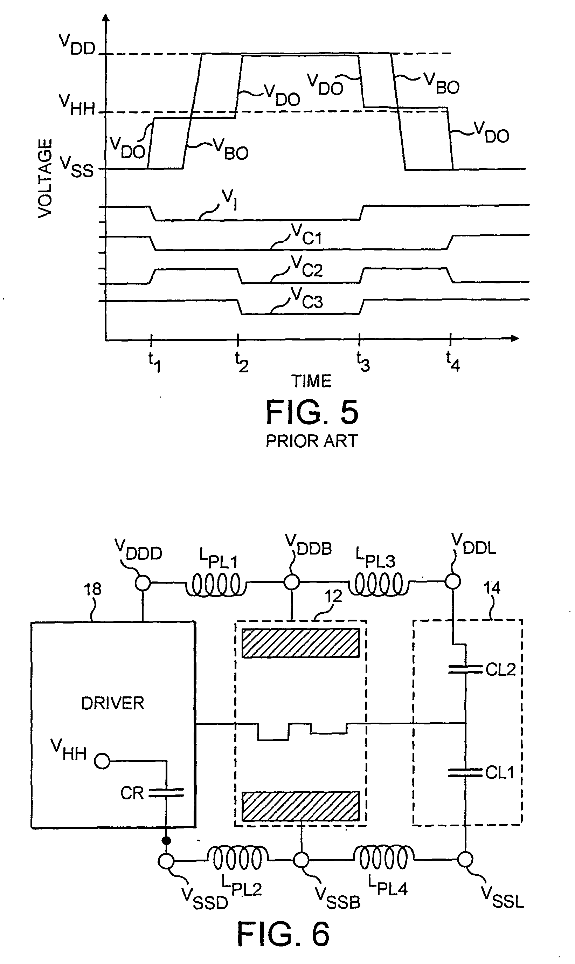

Fig. 5 shows waveforms resulting from the equivalent sequence of events when CL is smaller than or of a similar value to CB, in which case the transmission line character of CB and LB is more clearly evident. In response to a change of level of the input signal VI at time t1, Q1 is switched "OFF" while Q2 is switched "ON" driving VDO near to the level of VHH. An outward bound (or incident) wave of voltage amplitude equivalent to VHH travels along the transmission line. When it reaches the load, and since the load is reasonably small and cannot provide a significant path for the current in the incident wave, a reflected wave results tending to cancel the current of the incident wave. This reflected wave is also of amplitude equivalent to VHH but adds to the incident wave to give a voltage level at the load equal to VDD. The reflected wave travels back toward driver 18 until the whole length of the transmission line is at the level of VDD by time t2, being the time when the reflected wave actually reaches the driver 18, at which point control circuit 20 switches Q2 "OFF" and switches Q3 "ON' to complete the transition. Control circuit 20 can be designed in a variety of ways to control the timing of this to coincide with the return of the reflected wave. The timing for the current transition of VDO can be determined by observing and storing some characteristic of a previous transition to make adjustments to some circuit capable of storing and reproducing timed sequences, for example a digitally controlled delay line controlled by a digital counter.

Resonant Line Drivers have the potential to both reduce power consumption and produce well conditioned signal without ringing and overshoot. Unfortunately though, when certain unavoidable characteristics of typical physical implementations are taken into account, whilst low power consumption can be achieved, signal conditioning may be poor.

Fig. 6 shows the circuit of Fig. 3 but modified to make it more representative of a real physical implementation. Quite typically driver 18 is formed on silicon chip which is in turn contained in a chip package in turn mounted onto PWB 12. Often, though not necessarily, reservoir capacitor CR may be contained within the chip or chip package. Fig. 3 shows driver 18, PWB 12 and load 14 all sharing a common voltage reference level VSS. In an actual physical implementation this is often not the case since as shown in Fig. 6, ground voltage levels for driver 18, PWB 12 and load 14 (VSSD, VSSB and VSSL respectively) and power voltage levels for driver 18, PWB 12 and load 14 (VDDD, VDDB and VDDL respectively) are connected via parasitic package lead inductances LPL1, LPL2, LPL3, and LPL4 as shown. Also, in an actual physical implementation, the parasitic capacitances of the interconnect and load often occur not only between signal VSS but also between signal VDD as shown.

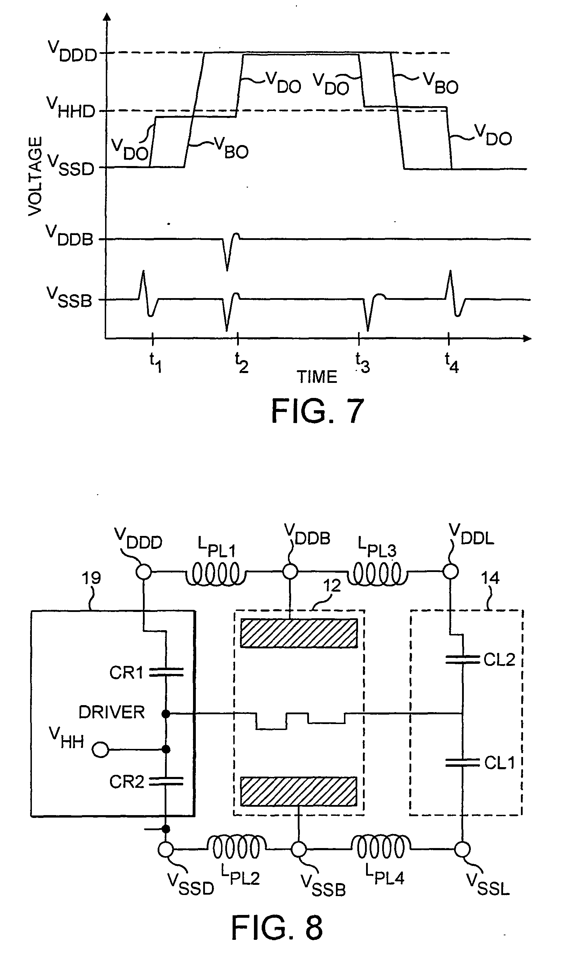

Turning to Fig. 7, Q2 of driver 18 in Fig. 2b is typically relatively large and consequently has a very low "ON" compared to, for example, QA or QB in the conventional driver of Fig. 1a, so the waveform produced by driver 18 as shown in Fig. 7 is very abrupt, causing VDO to go from the level of VSS to nearly the level of VHH in a relatively short space of time at about time t1. At the same time the current flowing from driver 18 into the interconnect increases very rapidly giving a very high rate of change of current (or di/dt). Since the change in current causes an equal and opposite change in current in the return path via LPL1 & LPL2, these parasitic inductances respond to such a rapid change in current by allowing an appreciable voltage difference to occur between VSSD & VSSB and between VDDD & VDDB as shown in Fig. 7 which shows the levels of VSSB and VDDB referred to VSSD and VDDD as reference.

In an actual application driver 18 would normally be part of an IC not only driving output signals but also receiving input signals. Unfortunately, since the input signals have considerable capacitance coupling with VSSB and VDDB, their levels tend to be determined in reference to VSSB and VDDB so that for example an input signal which is nominally at a low level will present to its receiver on the aforementioned IC, a voltage spike very similar to that shown for VSSB in Fig. 7 at time t1. This causes the possibility of the input signal being temporarily interpreted as being at a high level. As can be seen in Fig. 7, since all the change in output current from driver 18 in Fig. 6 is supplied from VSSD either via reservoir capacitor CR & Q2 in Fig. 2b or through Q1 in Fig. 2b, the most extreme disturbance is to the level of VSSB in relation to VSSD at time t1, t3 & t4. (At time t2 the change in current is supplied in part by VDDD via Q3 in Fig. 2b so the disturbance is less serious.) Therefore a signal which inputs to the aforementioned IC and because of its particular physical routing being coupled mainly to VSSB may suffer serious disturbance as received by a receiver circuit in the IC.

### Summary of the Invention

It is the aim of the present invention to provide improvements to resonant line drivers to allow their operation with low signal disturbance and better signal integrity whist still allowing the benefits of reduced power consumption. These improvements may be used either in combination or individually to provide a greater or less degree of benefit.

In accordance with a first aspect of the invention, an electronic driver circuit is provided for generating a circuit output signal providable to an electrical conductor that furnishes a conductor output signal providable to a load where the circuit and conductor output signals respectively making corresponding circuit and conductor output transitions approximately between a pair of output voltage levels between which there is an intermediate voltage level. Inductance and capacitance of the conductor and the load produce resonance that enables the conductor output signal to largely complete each conductor output transition while the circuit output signal is being held at approximately the intermediate voltage level for a non-zero intermediate-level holding period during the corresponding circuit output transition. The circuit includes at least a first capacitor element between the intermediate voltage level and each of the first and second voltage levels and at least a second capacitor element (preferably equal to the first capacitor element, e.g. a) between the intermediate voltage level and the second voltage level.

The first and second capacitor elements may form a split-reservoir capacitor.

A package lead inductance may exist between the electrical conductor and a source of each of the pair of output voltage levels. In this case the first and second capacitor elements are preferably such that a change in circuit output voltage causes return current flowing back into the driver to be split approximately equally between the package lead inductances. The first and second capacitor elements may provide decoupling capacitance between the output voltage levels.

In accordance with a second aspect of the invention, an electronic driver circuit is provided for generating a circuit output signal providable to an electrical conductor that furnishes a conductor output signal providable to a load. The circuit and conductor output signals respectively make corresponding circuit and conductor output transitions approximately between a pair of output voltage levels between which there is an intermediate voltage level. Inductance and capacitance of the conductor and the load produce resonance that enables the conductor output signal to largely complete each conductor output transition while the circuit output signal is being held at approximately the intermediate voltage level for a non-zero intermediate-level holding period during the corresponding circuit output transition. The circuit comprising a ramp control circuit for controlling partial circuit output transitions between at least one of the pair of output voltage levels and the intermediate level to provide a substantially non-zero transition time for a partial circuit output transition.

The partial circuit output transition is preferably controlled to be slow relative to other switching events in the circuit.

A pull-up transistor and a pull-down transistor may be provided for pulling the circuit output up to a first of the two output voltage levels and down to a second of the two output voltage levels, in which case the partial circuit output transition is controlled to be slower than the switching of the pull-up and pull-down transistors.

An intermediate level driving transistor can be provided, which, in switching-on drives the circuit output up to the intermediate voltage level and in switching-off permits the circuit output to be driven up to a first of the two output voltage levels. In this case the partial circuit output transition is controlled to be slower than the switching-off of the intermediate level driving transistor.

The partial circuit output transition time is preferably adjustable, for example it is controllable as a function of the time taken for the conductor output signal to largely complete a conductor output transition.

The control circuitry may comprise time-comparison circuitry for comparing the circuit output signal and the second control signal to determine whether the circuit output signal completes a circuit output transition before the second control signal completes the corresponding control transition and adjustment circuitry for adjusting the partial circuit transition time depending on the comparison.

Alternatively the comparator circuit preferably compares a level of the partial circuit output transition with a reference voltage that is approximately midway between the intermediate voltage level and an output voltage level to which the output is transitioning at a time approximately midway between a start of the partial circuit output transition and an expected completion of the partial circuit output transition.

Preferably, reference ramp circuitry may be provided for generating a reference ramp, together with comparator circuitry coupled to the reference ramp circuitry for comparing a partial circuit output transition with the reference ramp.

The time taken for a partial circuit transition is preferably controlled as a function of characteristics (e.g. characteristics determined from relative timing of two signals) of at least one previous circuit output transition.

Preferably the ramp control circuit controls a partial circuit output transition as a function of a current stored control value stored as a result of a previous partial circuit output transition.

In accordance with a third aspect of the invention, an electronic driver circuit is provided for generating a circuit output signal providable to an electrical conductor that furnishes a conductor output signal providable to a load. The circuit and conductor output signals respectively make corresponding circuit and conductor output transitions approximately between a first voltage, a second voltage and an intermediate voltage between the first and second voltages. In this aspect, the circuit comprises: a first transistor having (a) a first flow electrode coupled to a source of the first voltage, (b) a second flow electrode coupled to an output node from which a circuit output signal is provided, and (c) a control electrode responsive to a first control signal for controlling current flow between the first transistor's flow electrodes; a second transistor having (a) a first flow electrode coupled to a source of the second voltage, (b) a second flow electrode coupled to the output node, and (c) a control electrode responsive to a second control signal for controlling current flow between the second transistor's flow electrodes; and a third transistor having (a) a first flow electrode coupled to a source of the intermediate voltage, (b) a second flow electrode coupled to the output node, and (c) a control electrode responsive to a third control signal for controlling current flow between the third transistor's flow electrodes. Fourth and fifth transistors are connected between the control electrode of the third transistor and the sources of the first and second voltage levels respectively. Control circuitry selectively discharges the control electrode of the third transistor to the first and second voltage levels respectively through the fourth and fifth transistors such that the control electrode makes partial transitions between the first and second voltage levels. The output signal makes rising and falling circuit output transitions approximately between the first and second voltages controlled by the first, second and third control signals, and the circuit output signal stays approximately at the intermediate voltage for a non-zero intermediate-level holding period during each circuit output transition.

The features of the first, second and third aspects of the invention and their various preferred features may be combined in any combination.

In accordance with the first aspect of the invention, the split reservoir (or other) capacitor reduces ground and power reference differences (known as ground and power bounce) between a chip containing a resonant driver and the PWB on which it is mounted. The split reservoir capacitor also provides power and ground decoupling. In its second aspect the invention provides for a controlled slew rate ramp initiating an incident or outbound wave or turn-on and circuit methods for this. In a further aspect, the invention provides for the time taken to complete the controlled slew rate ramp to be adjusted approximately proportionately in time with the intermediate voltage holding period of the resonant driver.

The controlled slew rate ramp methods can not only further reduce ground and power bounce but also reduce unnecessary high frequency components in the signal seen at the load which can cause other signal integrity and radio frequency interference issues. A further aspect of the current invention lies in matching the "ON" resistance of the driver pull-up and pull-down transistors (for example Q3 and Q 1 in Fig. 2b) approximately to the characteristic impedance interconnect 12. A still further aspect of the invention relates to means for determining a feedback control signal to adjust the internal delay of a resonant line driver.

A number of preferred embodiments will now be described by way of example only, with reference to the drawings.

### Brief Description of the Drawings

Figs. 1 to 3 represent prior art resonant line driver circuits.
Figs. 4 and 5 are timing diagrams illustrating the operation of the circuit of Fig. 2b for different values of CL.
Fig. 6 represents a resonant line driver similar to that of Fig. 3 in a typical physical environment.
Fig. 7 is a timing diagram for the circuit of Fig. 6.
Fig. 8 represents a resonant line driver in accordance with a first embodiment of the invention.
Figs. 9 to 11 are timing diagrams illustrating the operation of the circuit of Fig. 8.
Fig. 12 represents a resonant line driver in accordance with a second embodiment of the invention.
Fig. 13 is a timing diagram illustrating the operation of the circuit of Fig. 12.
Fig. 14 represents a resonant line driver in accordance with a third embodiment of the invention.
Figs. 15 and 16 are timing diagrams illustrating the operation of the circuit of Fig. 14.
Fig. 17 is a diagram of a control circuit suitable for use in the circuit of Fig. 12 or Fig. 14 or other embodiments.
Fig. 18 illustrates a prior art control circuit.
Fig. 19 is a timing diagram for explanation of the operation of a resonant line driver in accordance with the second aspect of the invention.
Fig. 20 illustrates a control circuit suitable for use in accordance with the second aspect of the invention.
Fig. 21 expands upon Fig. 19.
Fig. 22 illustrates a control circuit alternative to that of Fig. 20.
Fig. 23 represents a resonant line driver in accordance with a further embodiment.
Fig. 24 is a timing diagram for the circuit of Fig. 23.
Fig. 25 illustrates in greater detail a comparator suitable for use in the circuit shown in Fig. 23.

### Detailed Description of the Preferred Embodiments

Turning to Fig. 8, it shows a circuit similar to that in Fig. 6 but instead of the reservoir capacitance being supplied entirely between the VSSD and VHHD circuit nodes, the reservoir capacitor is split into two capacitances CR1 and CR2. CR1 provides capacitance between VSSD and VHHD while CR2 provides capacitance between VDDD and VHHD. Since each of CR1 and CR2 provides reservoir capacitance in parallel, each of CR1 & CR2 can be made half the numerical size of CR in Fig. 6 to provide the same effective reservoir capacitance. But by using a split reservoir capacitor driver 19 in Fig. 8 is made more symmetrical so when a change in voltage of driver output signal VDO causes current to flow into or out of interconnect 12, a return current flows back into driver 19 split equally between package lead inductances LPL1 & LPL2.

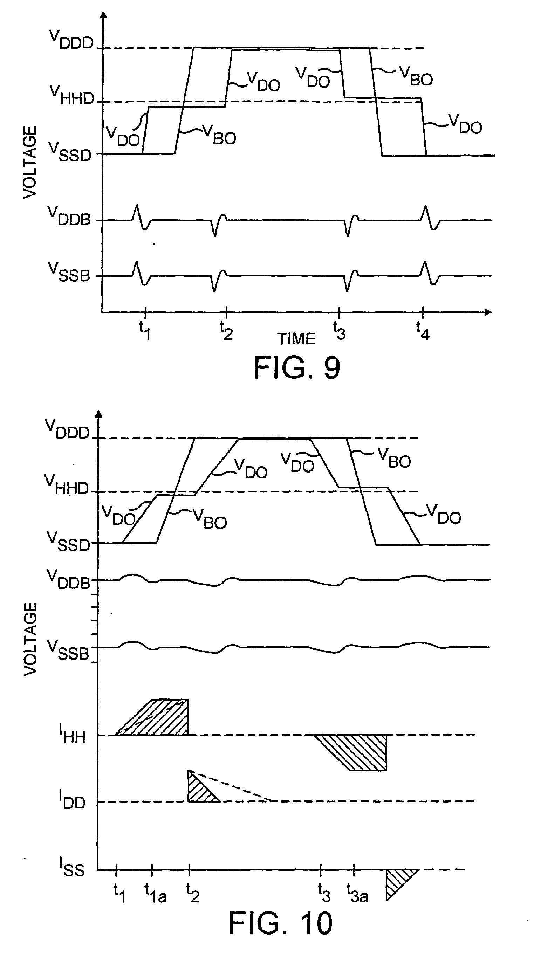

Fig. 9 shows waveforms that occur in relation to the circuit of Fig 8. Comparing Fig. 7 with Fig. 9, whereas at time t1 in Fig. 7 since in Fig. 6 all return current flows through LPL2 giving a large offset between VSSB and VSSD, at time t1 in Fig. 9 both VSSB and VDDB are offset approximately equally from VSSD and VDDD respectively but by a smaller amount since in the circuit of Fig. 8 any return current is split equally between package lead inductances LPL1 an LPL2. As a further benefit, the series combination of LPL1 and LPL2 provides a very useful degree of decoupling capacitance between VSSD and VDDD. For example, at time t2 in Fig. 9 some current is supplied from node VDDD to the driver output node via, for example MOSFET Q3 in Fig. 2b. The decoupling capacitance provided by the series combination of CR1 and CR2 can provide the necessary current which would otherwise need to be drawn externally through LPL1 causing further ground bounce.

Turning to Fig. 10, a second element of the current invention provides for a controlled slew rate ramp when at time t1, driver output signal is driven from the level of VSSD to VHHD. The positive going ramp takes output signal VDO smoothly at a controlled rate from the level of VSSD at time t1 nearly to the level of VHHD at time t1a and a negative going ramp takes output signal VDO smoothly at a controlled rate from the level of VDDD at time t3 nearly to the level of VHHD at time t3a.

Preferably the ramp is generated by a circuit of low output impedance so that the amplitude and duration of the ramp is largely unaffected by the degree of loading on output signal VDO. A controlled ramp considerably reduces the rate of change of current output from the driver and therefore the rate of change of return current through for example LPL1 and LPL2 and results in considerable reduction of power and ground bounce, as shown in Fig. 10 and yet adds only a small delay to the overall transit of the signal from source to load.

When the load approximates a transmission line the ramp commencing at time t1 in Fig.10 travels along the transmission line and reflects back toward the driver reaching it at time t2. At this point control circuit 20 disconnects output VDO from VHHD and connects it to VDDD via pull-up transistor for example Q3 in Fig. 2b. If Q3 is sized such that its "ON" resistance is matched to the characteristic impedance of the transmission line then the driver output voltage VDO smoothly approaches the level of VDDD without overshoot or undershoot to complete the transition. A similar sequence commences at time t3 in the opposite polarity transition and likewise Q1 in Fig.2b can be sized such that its "ON" resistance is matched to the characteristic impedance of the transmission line.

A disadvantage of the controlled ramp method is that a reduced portion of total charge for the transition is supplied from the reservoir capacitor. For example in Fig. 10 the shade areas under the IHH and IDD curves show the relative proportions of charge deliver from the VHHD node (i.e. reservoir capacitor) and VDDD power supply node. As can be seen in Fig. 10, about 75% of the charge is provided by the reservoir capacitor, the remaining 25% coming from the VDDD power supply. Also indicated in Fig. 10 (dotted lines) is that if the controlled ramp rate is made still slower the portion of charge supplied from the reservoir capacitor could drop still further to about 50%. Therefore the use of a controlled ramp leads to a slightly higher power consumption, though still much lower than a conventional driver but improves signal integrity and ground/power bounce. The timing requirements for signal integrity versus those for low power consumption and speed are therefore somewhat in opposition. Achieving a compromise between the requirements is the aim of a further element of the current invention.

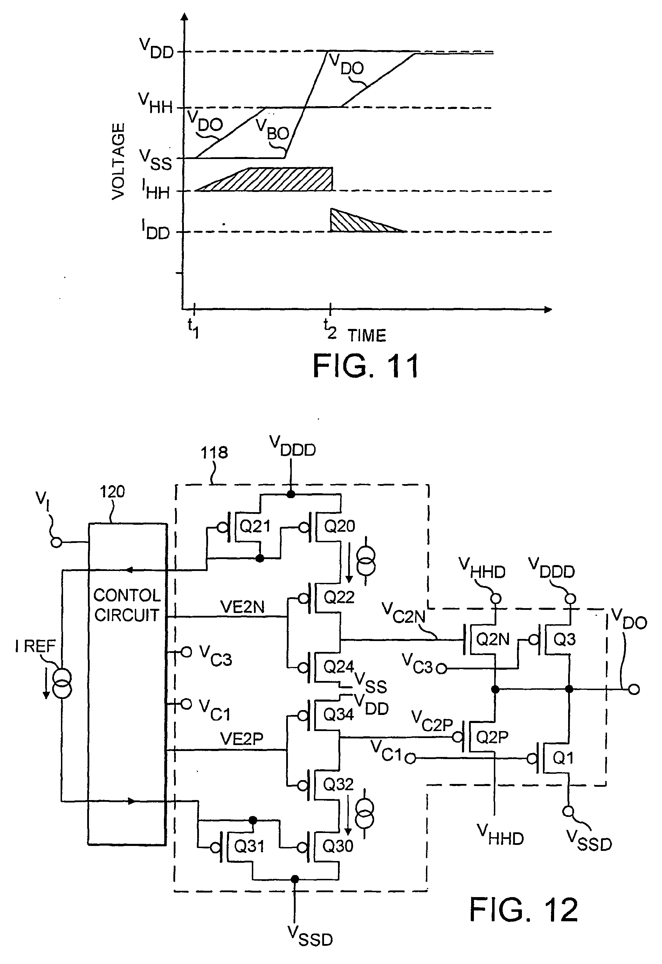

Looking again Fig. 10, if the ramp rate were approximately halved such that its duration is from t1 to t2 then as discussed above, the power consumption would increase so that a driver employing such a ramp rate might be unsuitable. On the other hand, if the same driver were driving an interconnect of about twice the length (and therefore delay), such a ramp time would again have low power consumption compared with a conventional driver as well as delivering good signal integrity as show in Fig. 11, whilst a ramp of the original speed (t1 to t1a) would bring only marginal further improvement in power consumption and speed and yet greatly increase the contribution of the driver to ground/power bounce. At the same time the signal would contain an excess of high frequency harmonics adding unnecessarily to radio frequency emission. If therefore the ramp circuit is made controllable (i.e. capable of delivering ramp times of variable duration within a range, and if the ramp time is controlled by the same circuit control mechanism used in control circuit 20 to adjust the intermediate level holding period of the resonant line driver, then the driver can operate over a range of load conditions (i.e. can drive load with varying transmission line delay or LC resonant frequency) and still produce waveforms which represent close to an optimum chosen compromise between, on the one hand power consumption and speed and on the other hand signal integrity.

Fig. 12 shows a resonant line driver 118 comprising a first embodiment of a ramp control circuit 118. Comparing it with the circuit in Fig. 2b, NMOS transistor Q2 has been replaced by a pair of transistors Q2N (an NMOS device) and Q2P (a PMOS device) with their respective channels connected in parallel. At the beginning of a transition of output signal VDO the gate of Q2N is charged (positively) by a flow of current from current mirror Q21/Q20 when Q22 switches "ON", and at the same Q24 is turned "OFF" whilst the gate of Q2P is charge (negatively) by a flow of current from current mirror Q31/Q30 when Q32 switches "ON" and at the same Q34 is turned "OFF".

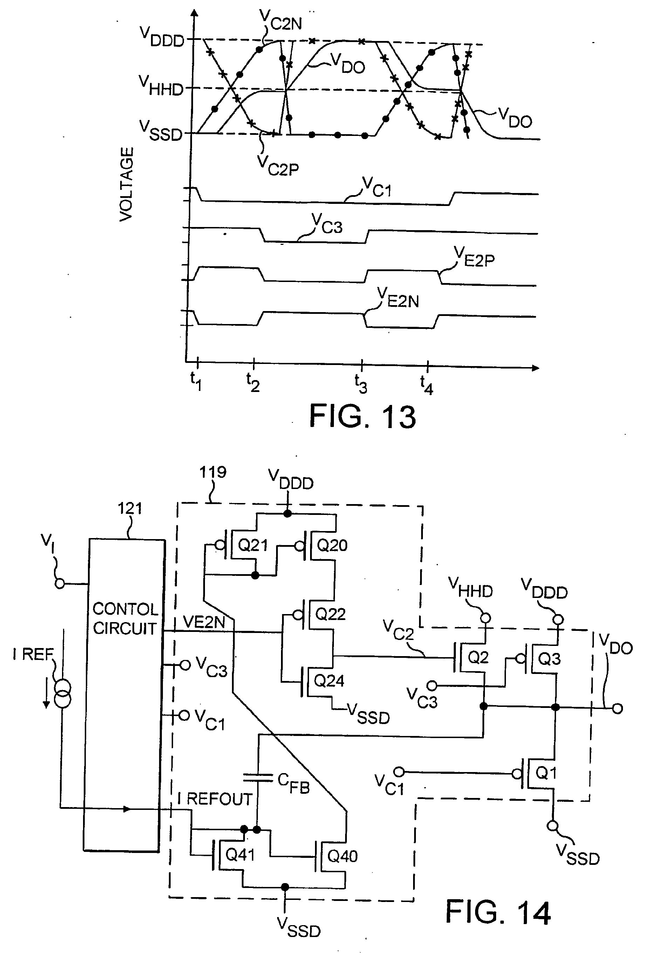

In a LOW to HIGH transition, for example that commencing at time t1 in Fig. 13, PMOS transistor Q2P is initially not conducting even after its gate electrode begins to fall because its channel cannot switch "ON" until the gate electrode become more negative than VHH. NMOS device Q2N on the other hand becomes conductive as soon as its gate electrode becomes more positive than VDO by at least the threshold voltage of Q2N. It will be seen that Q2N is therefore initially in a source follower configuration. During the ramp time signal, VDO is pulled gradually higher by a very low impedance, since a source follower configuration gives a very low output resistance. Q2P does eventually switch "ON" after the ramp is substantially complete and helps to attain a low overall "ON" resistance for Q2N and Q2P in parallel combination. At time t2 both Q2N and Q2P are rapidly switched "OFF", while pull-up transistor Q3 is switched "ON". In a HIGH to LOW transition, beginning at time t3, it is Q2P which switches "ON" first in source follower mode and Q2N which switches "ON" later so that the same pattern of operation occurs as described in relation the LOW to HIGH transition. Varying the value of current reference IREF allows variable ramp rates to be generated.

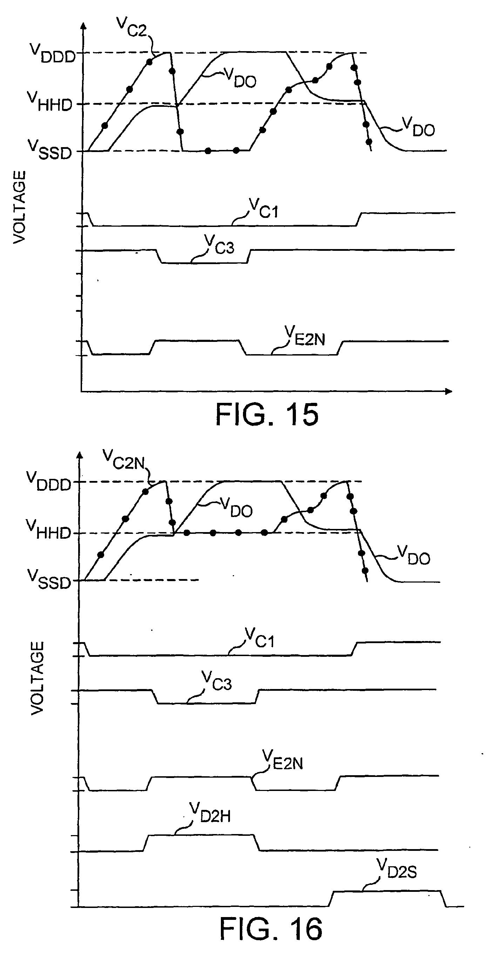

A disadvantage of the circuit of Fig. 12 is that, since CMOS P-channel devices are generally much less space efficient than N-channel devices, the circuit represents an increase in silicon area for the same value of "ON" resistance when compared to the circuit in Fig. 2b. Fig. 14 shows a resonant line driver comprising an alternative ramp control circuit 119 using a single NMOS device Q2 in place of the parallel combination of Q2N and Q2P in Fig. 12. Clearly for LOW-HIGH transitions Q2 can again be driven in a source follower mode to generate a variable ramp. In Fig. 14, the gate of Q2 is again charged during LOW-HIGH ramp when Q22 switches "ON" current mirror Q21/Q20 and at the same Q24 is turned "OFF". The reference current for mirror Q21/Q20 comes in turn from current mirror Q30/Q31, which is in turn controlled by current reference IREFOUT. For HIGH-LOW transitions, Q2 cannot be used as a source follower but is effectively configured as a common source switch which would normally switch "ON" very abruptly when the gate became more positive than VHH by an amount equal to the threshold voltage of Q2. However if a feedback capacitor CFB is place between output signal VDO and the input to mirror Q41/Q40, then the ramp rate generates a rate dependent current feedback which subtracts from reference current IREFOUT. Thus the circuit uses negative feedback to control the ramp rate to depend on the reference current input, since if the ramp is too slow the gate voltage will build at the input to mirror Q41/Q40 tending to correct the rate to that desired. In effect therefore the ramp again has a low output impedance. As shown in Fig. 15, for HIGH-LOW transitions the gate of Q2 is charged on a steadily increasing ramp whilst for HIGH-LOW transitions the gate voltage rises quite quickly at first and then slowly during an active period whilst the ramp rate is controlled. Thus capacitor CFB can be described as checking the rate of rise of the current to the control electrode of transistor Q2 when the circuit output signal falls from VDD to VSS.

A drawback with the circuit of Fig. 14 is that on HIGH-LOW transitions there is an appreciable delay from beginning to charge the gate of Q2 to the point where Q2 first becomes conductive until driver output VDO begins to move. As shown in Fig. 16. however, during the period when VDO is high, it is not necessary to discharge the gate of Q2 to the level of VSSD in order to switch Q2 "OFF". If the gate is discharged only to VHHD as shown in Fig. 16, Q2 will still be switched "OFF" but can be switched "ON" again much more quickly at the start of the next HIGH-LOW transition. This can be achieved by replacing Q24 in Fig. 14 with two transistors, one discharging the gate of Q2 to VSSD and the other discharging the gate of Q2 to VHHD under control of suitably provisioned control signals VD2S and VD2H shown in Fig. 16. Alternatively the gate of Q2 can be first discharged to VSSD and then precharged to the level of VHHD only before HIGH-LOW transitions.

An advantage of such a modified form of the circuit of Fig. 14 can be seen by comparing Fig. 16 for such a modified circuit with Fig. 15 for the circuit as shown. The peak voltage stress between the gate and channel of switch Q2 is approximately halved. E.g., after a low/high transition, all that is required to switch Q2 off is to return the gate electrode to VHH. This reduces power consumption and allows a thinner oxide layer to be used in the manufacture of the MOSFET channel of Q2. Note that this advantage is independent of the particular rise time control scheme or timing of control for the partial output transitions. Note also that it is described in the context of a circuit comprising exclusively N-channel technology, but is equally applicable to P-channel technology or a mixture of N and P-channels. By way of example, the same principal could be applied to the circuit of Fig. 12, with suitable modifications.

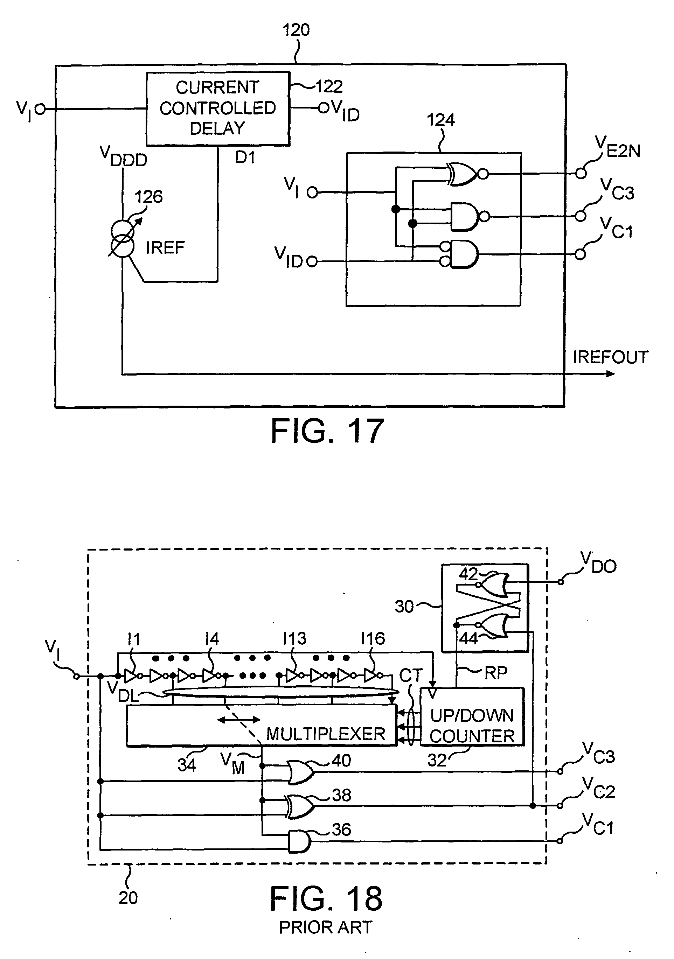

Fig. 17 shows a block diagram of a control circuit 120 in which the same current reference controls both the intermediate level holding period of a resonant line driver via controllable delay D1 and provides current IREFOUT to a ramp circuit (for example in driver 119 of Fig. 14) so that the ramp period tracks the intermediate level holding period for chosen optimum over a range of timing conditions. As described above, IREFOUT can be adjusted according to some characteristic of a previous transition as described in the prior art.

For example, Fig. 18 shows a control circuit described in US patent No. 6,201,420, in which the duration of the intermediate level holding period is set by the value of an up/down counter 32, in turn controlled by a comparator circuit 30 which compares the timing of circuit output signal VDO with control signal VC2 to produce feedback signal RP. However, comparator 30 is designed to compare the relative timing of two fast transitioning signals and may be unreliable or inaccurate for use in a resonant line driver using a controlled ramp as described previously. A further aspect of the current invention therefore provides a means of adjusting the intermediate level holding for resonant line drivers using a controlled ramp.

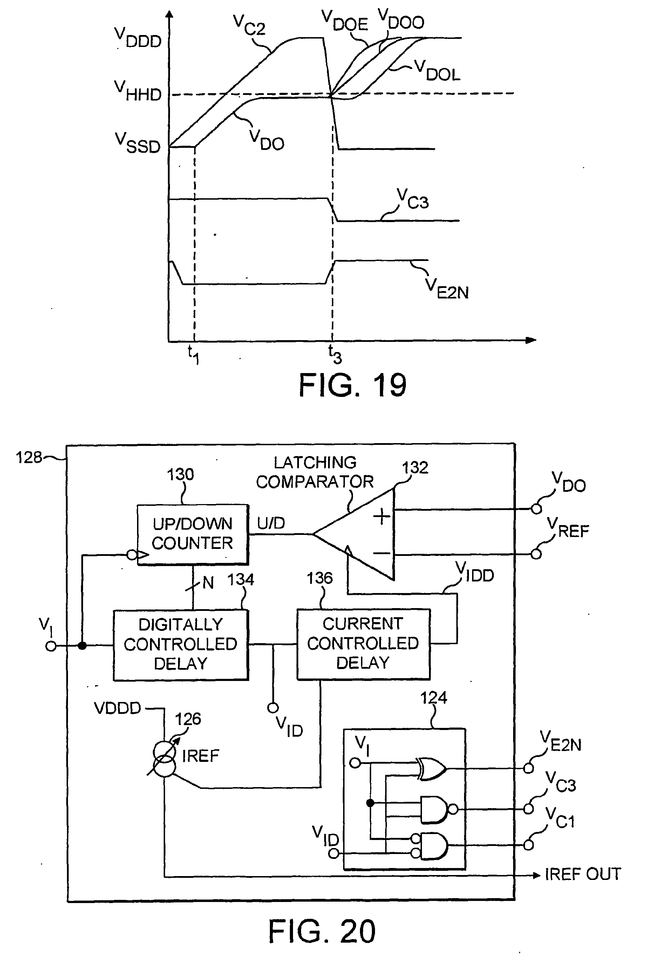

Fig. 19, for clarity, shows only the low-to-high transition of a resonant line driver using a controlled ramp. It shows an initial ramp beginning at time t1 followed by an intermediate level holding period after which the reflection of the initial ramp at time t1 (let it be called "initial reflection") arrives at approximately time t3. Time t3 is the time of the transitioning of control signals VC3 and VE2N as determined by the control circuitry. An element of the current invention is the positioning of an optimum timing for the transitioning of control signals VC3 and VE2N at t3 such that it coincides as nearly as possible with initial reflection. When this optimum timing is achieved, output signal VDO rises with approximately the same slope starting from time t3 as it does during the initial ramp starting at time t1. This optimum timing is depicted by voltage waveform VDOO in Fig. 19. When initial reflection arrives in early, in advance of time t3, signal VDO rises more quickly than the initial ramp beginning at time t1 as indicated by waveform VDOE. Conversely, when initial reflection arrives late in relation to time t3, signal VDO rises with a slope similar to the initial ramp at time t1 but commencing some time after time t3 as depicted by waveform VDOL.

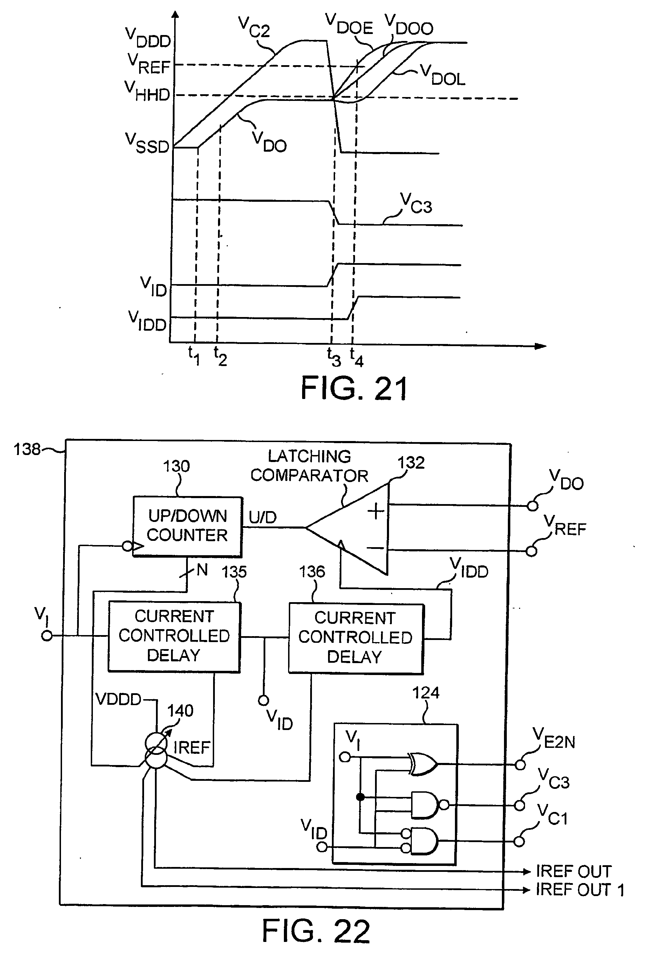

Turning to Fig. 20, this shows control circuit 128 comprising timing circuit and control loop for use in a resonant line driver using a controlled ramp, whilst Fig. 21 depicts waveforms which occur in relation to the operation of control circuit 128.

Control circuit 128 contains latching comparator circuit 132 which has level sensitive inputs receiving signals VDO and VREF and furnishes digital output signal U/D to an N-bit up/down counter 130 in response to clock signal input VIDD. Signal U/D is set to a logic "high" on the rising edge of VIDD if at that time signal VDO has a higher voltage than signal VREF or to a logic "low" on the rising edge of VIDD if at that time signal VDO has a lower voltage than signal VREF. Signal U/D controls the N-bit up/down counter 130 such that if signal U/D is at a logic "high" during the logic "high" to logic "low" transition of input signal VI then the counter value increments. Conversely if signal U/D is at a logic "low" during the logic "high" to logic "low" transition of input signal VI then the counter value decrements. Counter 130 in turns controls digitally controlled delay circuit 134 such that input signal VI is delayed in time by an amount dependent upon the current value stored by counter 130.

Signal VID, the delayed version of signal VI, is output from delay circuit 134 and in turn initiates the transitioning of output signals VE2N, VC3 and VC 1 at time t3 in Fig. 21. Current controlled delay circuit 136 further delays signal VID to produce signal VIDD which transitions at time t4 in Fig. 21. Signal VIDD in turn is the clocking signal for latching comparator 132. Delay circuit 136 is controlled by an output of current source 126 which supplies current IREF such that the greater the value of IREF the shorter the delay produced by delay circuit 136. Current source 126 furnishes a second equal or proportional current to output IREFOUT which in turn can control the rise time of the ramp beginning at time t1 in Fig. 21. When optimum timing is achieved, output signal VDO rises with approximately the same slope starting from time t3 as it does during the initial ramp starting at time t1, as depicted by waveform VDDO.

Delay circuit 136 is arranged to produce a delay always equal to approximately one half of the duration of the ramp commencing at time t1 in Fig. 21. Input signal VREF on the other hand has a potential approximately midway between the potential of VHHD and VDDD as shown in the figure. When optimum timing is achieved, waveform VDOO results such that its potential approximately equals VREF at time t4 producing an indeterminate output U/D from latching comparator 132.

On the other hand, if optimum timing has not been achieved, either waveform VDOE or waveform VDOL will result, and latching comparator 132 will drive its output signal, U/D to a logic "high" or logic "low" respectively. Since signal U/D controls the timing of signal VID and hence the positions of time t3 in Fig. 21 via counter 130 and delay circuit 134 in Fig. 20, the overall operation of the circuit is such that output signals VE2N, VC3 and VC1 are controlled to occur at or near an optimum time. Those skilled in the art will recognize that latching comparator 132, up/down counter 130 and digitally controlled delay 134 together comprise elements of a control loop or more specifically a delay locked loop when used as the control circuit in a resonant line driver.

Turning to Fig. 22, it shows control circuit 138. which is similar to control circuit 128 in Fig. 20 but differs in that digitally controlled delay 134 in of control circuit 128 is replaced by current controlled delay 135 in control circuit 138. Furthermore delay 135 is controlled by a current supplied from digitally controlled current source 140 in place of fixed current source 126 in control circuit 128. Digitally controlled current source 140 supplies several equal or proportional output currents whose magnitudes are controlled as some function of the n-bit binary control input supplied by up/down counter 130 in control circuit 138, but typically the output currents of current source 140 are substantially proportional or inversely proportional to the binary value control input supplied by counter 130. Since counter 130 in control circuit 138 controls current source 140 which in turn controls delay 135 and via current controlled delay 136 enables latching comparator 132, these again comprise elements of a delay locked loop.

An advantage of control circuit 138 when compared with control circuit 128 is that control circuit 138 can supply additional control currents IREFOUT and IREFOUT1 which are proportional to the control input current to current controlled delay 135. As described in relation to control circuit 120 in Fig. 17, IREFOUT in Fig. 22 can be used to control the rise time of a ramp circuit allowing the ramp period to track the intermediate level holding period in a resonant line driver. The further usefulness of IREFOUT1 is described later. As described in relation to control circuit 128 in Fig. 20, control circuit 138 likewise contains current controlled delay 136, the purpose of which is to provide clock signal VIDD to latching comparator circuit 132 such that signal VDO is compared at time t3 to reference voltage VREF as shown in Fig. 21. Voltage VREF and time t3 typically have their intersection as shown in Fig. 21 coinciding with waveform VDOO so that waveform VDOE can be discriminated from waveform VDOL to produce loop feedback signal U/D.

A particular difficulty when physically implementing control circuits 128 or 138 may be in designing latching comparator 132 to work at sufficiently high speed and providing it with reference and clocking inputs of sufficient precision. For example, whilst in Fig. 21 voltage levels VHHD and VDDD are shown as time invariant, in a physical implementation both VDDD and VHHD are subject to change, particularly the level of VHHD when it is supplied from a reservoir capacitor. Therefore the choice of appropriate level for VREF in relation to the current and immediately prior levels of VHHD and VDDD and circuitry required to furnish signal VREF may become quite complex issues. Likewise, the timing of signal VIDD in control circuits 128 or 138 needs to be accurate and repeatable to a degree which may prove hard to achieve. Furthermore, latching comparator 132 in control circuits 128 or 138 notionally compares the voltage of signal VDO to the voltage of signal VREF at a single instant on the rising edge of clocking signal VIDD. In reality though, due to the finite speed of circuit elements internal to latching comparator 132, that comparator will tend to compare the values of inputs signal VDO and VREF averaged throughout the time duration of a sampling window, approximately (though not precisely) coinciding with the rising edge of clocking input signal VIDD.

All of these uncertainties may combine to make circuit design difficult and circuit operation erratic. In accordance with a further embodiment of the current invention improved means are provided for furnishing loop feedback signal U/D in control circuit 128 and 138. This is achieved in part by redefining the inputs to latching comparator 132 to demand less precision and in part by providing an internal circuit for latching comparator 132 which is novel and particular to the application and further relaxes the timing accuracy demanded of clocking signal VIDD.

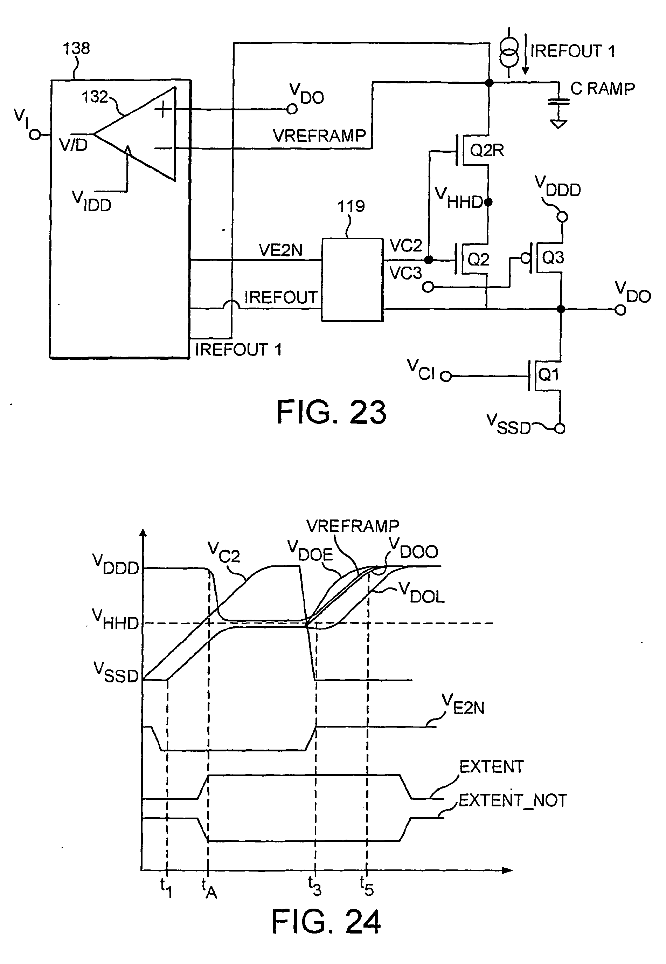

Fig. 23 shows an alternative resonant line driver comprising a control circuit 138, a ramp circuit 119 similar to that shown in Fig. 14, output MOSFET's Q1, Q2 and Q3 and additional circuitry comprising N-channel MOSFET Q2R and capacitor CRAMP. Capacitor CRAMP furnishes a signal VREFRAMP which functions as described below. The source and drain terminals of N-Channel MOSFET Q2R are connected to signals VHHD and VREFRAMP respectively.

Referring to Fig. 24, reference current output IRFEOUT1 from control circuit 138 initially charges capacitor CRAMP high to the voltage level of VDD. When signal VC2 rises initiating a low to high transition at time t1 and further rises above the level of VHHD time tA, N-Channel MOSFET Q2R turns "ON", discharging capacitor CRAMP and signal REFRAMP to the level of VHHD. Then at time immediately prior to time t3, signal VC2 falls. Prior to the falling edge of signal VC2, output signal VDO is strongly held at a level close to the level of VHHD because large N-channel MOSFET Q2 is "ON" The falling edge of VC2 is what initiates the ramp beginning at time t3 of signal VDO when N-channel MOSFET Q2 turns "OFF".

Waveform VREFRAMP has a slope between time t3 and t5 that is arranged to be substantially the same as waveform VDDO in Fig. 21. By using waveform VREFRAMP in place of signal VREF, output signal VDO can be compared with VREFRAMP at any time between times t3 and t5 and the same result can be obtained, thus considerably relaxing the timing requirements for signal VIDD in part of Fig. 23.

It is a considerable benefit of the current invention and in particular the circuit shown in Fig. 23 that at substantially the same time (t3 in Fig. 24) that N-channel MOSFET Q2N turns "OFF" initiating the ramp of VDO, N-channel MOSFET Q2R also turns "OFF" allowing IREFOUT1 to begin charging capacitor CRAMP. The close timing coincidence of these two events at time t3 is very precise because both MOSFET Q2 and Q2R can be N-channel devices formed on the same substrate sharing a common gate signal VC2 and a common source signal VHHD. Furthermore, the slope of signal VREFRAMP between time t3 and t5 is proportional to the reference current IREFOUT1, which is in turn proportional to the reference current IREFOUT, which (through ramp circuit 119) substantially determines the slope of the VDO ramp beginning at time t1. Therefore the slope of signal VREFRAMP between times t3 and t5 can be arranged to be always substantially the same as the slope of the ramp of output signal VDO beginning at time t1, and when signals VDO and VREFRAMP are compared at any time between t3 and t5 by latching comparator 132 (Fig. 23) then a loop feedback signal U/D can be furnished, which very accurately discriminates waveform VDOE of output signal VDO from waveform VDOL of output signal VDO. Thus up/down counter 130 and digitally controlled current source 140 allow current controlled delay 135 in control circuit 138 (all shown in Fig. 22) to be adjusted very close to an optimum value.

Instead of comparing the voltage level of output signal VDO to the voltage level of signal VREFRAMP at some a single time between time t3 and t5 in Fig. 24, still further accuracy may be obtained if the difference voltage between the two signals is time integrated between times t3 and t5 using what (for ease of reference) will be called an integrating latching comparator. Such a comparator has inherent advantages in terms of accuracy and noise immunity. However when implemented in a resonant line driver operating at high speed there may be difficulties in furnishing to an integrating latching comparator a signal or combination of signals that accurately delimits the desired period of integration. A further embodiment of the current invention employs an integrating latching comparator circuit which largely overcomes this issue.

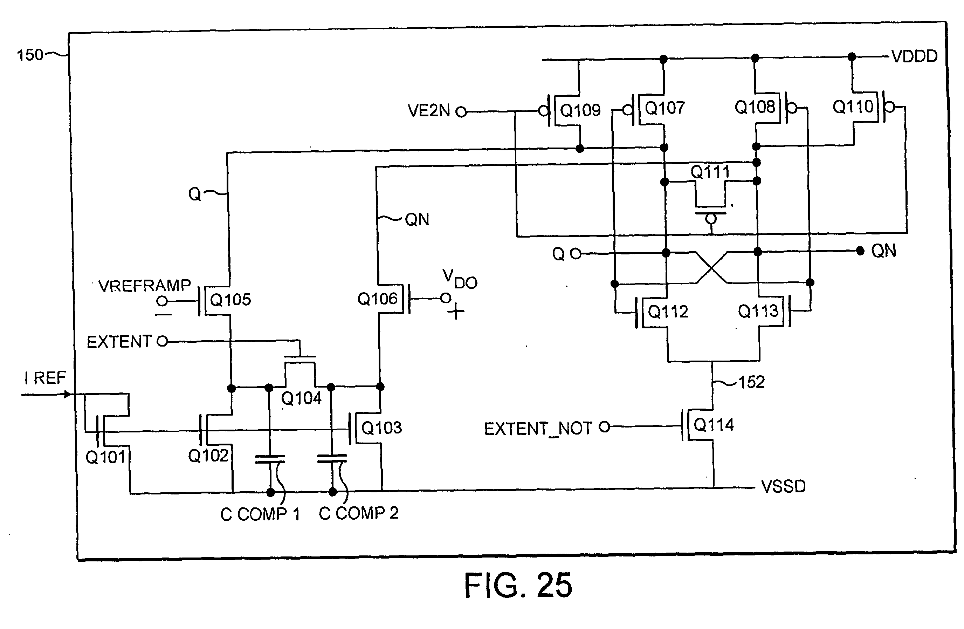

Turning to Fig. 25, this figure shows an integrating latching comparator 150 with comparator inputs VREFRAMP and VDO and furnishing comparator outputs Q and QN. Integrating latching comparator 150 also accepts a reference current IREF and latching control signals VE2N, EXTENT and EXTENT_NOT where suitable. Example timing of for these control signals is shown in the lower part of Fig. 24.

The input stage of integrating latching comparator 150 comprises capacitors CCOMP1 and CCOMP2, current bias generating N-channel MOSFETS Q102 and Q103, shorting N-channel MOSFET Q104 and differential input N-channel MOSFETs Q105 and Q106. Output nodes Q and QN are rapidly shorted, upon VE2N going to a low level shortly before time t1 in Fig. 24, and are driven to the voltage level ofVDDD by P-channel MOSFETs Q111, Q109 and Q110. Initially N-channel MOSFETs Q105 and Q106 act as source followers with bias current supplies by N-channel MOSFETs Q102 and Q103 and therefore capacitors CCOMP1 and CCOMP2 track the voltage levels of input signals VREFRAMP and VDO shifted lower by the gate-source bias voltage of Q105 and Q106. Then, when signal EXTENT goes to a high level, N-channel MOSFET Q104 is switched "ON" and shorts source terminals of N-channel MOSFETs Q105 and Q106 so that they now function as a differential pair with bias current again supplied by N-channel MOSFETs Q102 and Q103. The output current of the differential pair flows to output nodes Q and QN so that when, shortly before time t3 in Fig. 24, VE2N goes to a high level and Q109, Q110 and Q111 are switched "OFF", this output current begins charging output nodes Q and QN and associated capacitance (provided mainly by the gate capacitance of P-channel MOSFETs Q107 and Q108 and N-channel MOSFETs Q112 and Q113). The current source formed by Q102 and Q103 is arranged to supply only a modest amount of current so that even if VE2N happens relatively far in advance of time t3, output nodes Q and QN remain quite near to the level of VDDD and thus the relative timing of VE2N is non-critical in relation to time t3 save that it should go to a low level in advance of time t3. Now when input signals VREFRAMP and VDO begin their respective ramps at or near time t3, being connected to the gate terminals of N-channel MOSFETs Q105 and Q106, the respective source terminals Q105 and Q106 shorted by Q104 also begin to rise in voltage and to charge capacitors CCOMP1 and CCOMP2.

Note that when Q114 is closed for regeneration, Q104 is closed and serves to separate the differential pair of Q 105 and Q 106 at that time.

The integrating latching comparator 150 has a positive input VDO which receives the partial output transition, and a negative input VREFRAMP which receives a signal corresponding to (i.e. representative of) a reference ramp. The integrating latching comparator accumulates charge on the comparator output nodes (Q and QN) only during a time when either of the two input signals is rising. It provides an average comparison over the whole ramping period, i.e. over the time of the partial output transition.

A positive feedback regeneration circuit comprising the transistors Q 107 to Q114 receives charge at the comparator output nodes Q and QN via the differential input transistor pair. The regeneration circuit takes a small difference on nodes Q and QN, and, when EXTENTNOT causes Q114 to conduct, it amplifies this small difference to a full rail voltage.

Capacitors CCOMP1 and CCOMP2 are sized such that charging them requires quite a large current in relation to the modest bias current supplied by Q102 and Q103 so that the total bias current through the differential pair formed by Q105 and Q106 becomes quite large, but only while input signals VDO and VREFRAMP continue to rise. The circuit therefore embodies an inherent feature which tends to integrate the difference voltage between inputs VREFRAMP and VDO only during their respective ramp period between time t3 and t5 in Fig. 24. This feature further relaxes the timing precision required of control input signals to integrating latching comparator 150. By time t5 in Fig. 24, the difference voltage between inputs VREFRAMP and VDO will have been time integrated by charge accumulation to produce a small difference in the voltage levels of output nodes Q and QN. Finally this voltage is amplified to a full rail voltage when signal EXTENT_NOT goes to a high level after time t5 in Fig. 24, since the current flowing through N-channel MOSFET Q114 strongly biases cross coupled N-channel MOSFET pair Q112 and Q113, which regenerate any pre-existing voltage difference at output nodes Q & QN by positive feedback assisted by a similar mechanism applying to cross coupled P-channel MOSFET pair Q107 and Q108.

Again the timing of the rising edge of control signal EXTENT_NOT is non-critical in relation to time t5 in Fig. 24, save that it should occur after time t5. The final state of output signals Q & QN will be such that one is at the level of VDDD and the other at the level of VSSD depending on the time integrated difference voltage between input signals VREFRAMP and VDO between time t3 and t5 in Fig. 24. Integrating latching comparator 150 along with suitable circuitry to furnish control signals EXTENT and EXTENT_NOT could therefore replace latching comparator 132 in control circuit 138 of Fig. 23 with one of its output signal Q or QN chosen for appropriate logic polarity furnishing loop feedback signal U/D in Fig. 23.

## Claims

1. An electronic driver circuit for generating a circuit output signal providable to an electrical conductor (12) that furnishes a conductor output signal providable to a load (14), the circuit and conductor output signals respectively making corresponding circuit and conductor output transitions approximately between a pair of output voltage levels (V_{DD}, V_{SS}) between which there is an intermediate voltage level (V_{HH}), inductance and capacitance of the conductor and the load producing resonance that enables the conductor output signal to largely complete each conductor output transition while the circuit output signal is being held at approximately the intermediate voltage level for a non-zero intermediate-level holding period during the corresponding circuit output transition, the circuit comprising a ramp control circuit (118, 119) for controlling partial circuit output transitions between at least one of the pair of output voltage levels and the intermediate level to provide a substantially non-zero transition time for a partial circuit output transition.

2. A driver circuit according to claim 1 wherein the partial circuit output transition is controlled to be slow relative to other switching events in the circuit.

3. A driver circuit according to claim 1 or 2, further comprising a pull-up transistor (Q3) and a pull-down transistor (Q1) for pulling the circuit output up to a first of the two output voltage levels and down to a second of the two output voltage levels, wherein the partial circuit output transition is controlled to be slower than the switching of the pull-up and pull-down transistors.

4. A driver circuit according to claim 1, 2 or 3, further comprising an intermediate level driving transistor (Q2, Q2N) which in switching-on drives the circuit output to the intermediate voltage level and in switching-off permits the circuit output to be driven to a first of the two output voltage levels, wherein the partial circuit output transition is controlled to be slower than the switching-off of the intermediate level driving transistor.

5. A driver circuit according to any one of the preceding claims, wherein the partial circuit output transition time is adjustable.

6. A driver circuit according to any one of the preceding claims, wherein the partial circuit output transition time is controllable as a function of the time taken for the conductor output signal to largely complete a conductor output transition.

7. A driver circuit according to claim 1 wherein the control circuitry comprises:
time-comparison circuitry for comparing the circuit output signal and the second control signal to determine whether the circuit output signal completes a circuit output transition before the second control signal completes the corresponding control transition; and
adjustment circuitry for adjusting the partial circuit transition time depending on the comparison.

8. A driver circuit according to claim 1, comprising reference ramp circuitry for generating a reference ramp, and comparator circuitry coupled to the reference ramp circuitry for comparing a partial circuit output transition with the reference ramp.

9. A driver circuit according to claim 8, wherein the comparator circuitry compares a level of the partial circuit output transition with a reference voltage (V_{REF}) that is approximately midway between the intermediate voltage level (V_{HHD}) and an output voltage level to which the output is transitioning (V_{DDD}, V_{SSD}) at a time (t₄) approximately midway between a start (t₃) of the partial circuit output transition and an expected completion of the partial circuit output transition.

10. A driver circuit according to claim 8, wherein the comparator circuitry comprises an integrating latching comparator to provide an average comparison between a partial circuit output transition and a signal representative of the reference ramp over substantially the whole time of the partial output transition.

11. A driver circuit according to claim 10, wherein the comparator comprises:
a first input (V_{DO}) for receiving the partial circuit output transition;
a second input (V_{REFRAMP}) for receiving a signal representative of a reference ramp; and
a pair of output nodes (Q and QN);
wherein the integrating latching comparator accumulates charge on the comparator output nodes only during a time when one of the first and second input signals is rising.

12. A driver circuit according to any one of claims 8 to 11, further comprising adjustment circuitry for adjusting the partial circuit transition time depending on the comparison.

13. A driver circuit according to any one of the preceding claims, wherein the time taken for a partial circuit transition is controlled as a function of characteristics of at least one previous circuit output transition.

14. A driver circuit according to claim 13, wherein said characteristics are determined from relative timing of two signals.

15. A driver circuit according to any one of the preceding claims, wherein the ramp control circuit comprises a source follower for driving the circuit output signal in a controlled manner.

16. A driver circuit according to any one of the preceding claims, comprising a switch (Q2N) connected between a source of the intermediate voltage level (V_{HH}) and the circuit output signal, wherein the ramp control circuit comprises a current mirror (Q20, Q21) which supplies a current to the switch to drive the circuit output signal in a controlled manner.

17. A driver circuit according to claim 16, further comprising a controlled current source (120) for supplying a controlled current to the current mirror.

18. A driver circuit according to claim 17, wherein the current is controlled as a function of the time taken for the conductor output signal to largely complete a conductor output transition.

19. An electronic driver circuit in accordance with any one of the preceding claims, coupled between sources of different first, second, and third supply voltages, the second supply voltage (V_{HH}) lying between the first and third supply voltages, the circuit comprising:
control circuitry responsive to a circuit input signal for generating different first, second, and third control signals;
a first switch (Q3) having (a) a first flow electrode coupled to the source of the first supply voltage, (b) a second flow electrode coupled to an output node from which a circuit output signal (V_{DO}) is provided, and (c) a control electrode responsive to the first control signal for controlling current flow between the first switch's flow electrodes;
a second switch (Q1) having (a) a first flow electrode coupled to the source of the second supply voltage, (b) a second flow electrode coupled to the output node, and (c) a control electrode responsive to the second control signal for controlling current flow between the second switch's flow electrodes; and
a third switch (Q2) having (a) a first flow electrode coupled to the source of the third supply voltage, (b) a second flow electrode coupled to the output node, and (c) a control electrode responsive to the third control signal (V_{C2}) for controlling current flow between the third switch's flow electrodes, the circuit output signal making rising and falling circuit output transitions approximately between the first and third supply voltages, the circuit output signal staying approximately at the second supply voltage for a non-zero intermediate-level holding period during each circuit output transition, the transition time between the first and third supply voltages and/or between the second and third supply voltages being controlled.

20. A driver circuit according to claim 19, the circuit output signal making rising and falling circuit output transitions approximately between the first and third supply voltages, wherein the third switch operates as a source follower such that the output node follows its control electrode voltage in a controlled manner.

21. A driver circuit according to claim 19, wherein the third switch is an N-channel transistor, and wherein a capacitor (C_{FB}) is provided for checking the rate of rise of the current to the control electrode of the third transistor when the circuit output signal falls from the first voltage to the third voltage.

22. A driver circuit according to any one of the preceding claims, wherein a ramp control circuit (118, 119) controls a partial circuit output transition as a function of a current stored control value stored as a result of a previous partial circuit output transition.

23. The driver circuit of claim 19, wherein
the first switch is a first transistor (Q3)
the second switch is a second transistor (Q1)
the third switch is a third transistor (Q2); and further comprising
fourth and fifth transistors connected between the control electrode of the third transistor and the sources of the first and second voltage levels respectively, and control circuitry for selectively discharging the control electrode of the third transistor to the first and second voltage levels respectively through the fourth and fifth transistors such that the control electrode of the third transistor makes partial transitions between the first and second voltage levels.

24. A driver circuit according to claim 23, further comprising control circuitry to provide the first, second and third control signals to cause the circuit output signal to stay approximately at the intermediate supply voltage for a non-zero intermediate-level holding period during each circuit output transition.

25. A driver circuit according to claim 23 or 24, wherein the control circuit comprises timing control circuitry to control times of transition of the circuit output signal between one of the first and second supply voltages and the intermediate supply voltage.

26. A driver circuit according to claim 24, wherein the control circuit comprises reference ramp circuitry for generating a reference ramp, and comparator circuitry coupled to the reference ramp circuitry for comparing a partial circuit output transition with the reference ramp.

## Patentansprüche

1. Elektronische Treiberschaltung zum Erzeugen eines Schaltungsausgangssignals, das an einen elektrischen Leiter (12) bereitstellbar ist, der ein Leiterausgangssignal liefert, das an eine Last (14) bereitstellbar ist, wobei das Ausgangssignal der Schaltung und des Leiters jeweils annähernd zwischen einem Paar von Ausgangsspannungspegeln (V_{DD}, V_{SS}), zwischen denen ein mittlerer Spannungspegel (V_{HH}) vorliegt, einen entsprechenden Ausgangsübergang vollziehen, wobei die Induktivität und die Kapazität des Leiters und die Last eine Resonanz erzeugen, die es ermöglicht, dass das Leiterausgangssignal jeden Leiterausgangsübergang im Wesentlichen abschließt, während das Schaltungsausgangssignal für eine Nichtnull-Mittelpegelhalteperiode während des entsprechenden Schaltungsausgangsübergangs annähernd auf dem mittleren Spannungspegel gehalten wird, wobei die Schaltung eine Rampensteuerungsschaltung (118, 119) zum Steuern von partiellen Schaltungsausgangsübergängen zwischen wenigstens einem Pegel des Paars von Ausgangsspannungspegeln und dem mittleren Pegel umfasst, um für einen partiellen Schaltungsausgangsübergang eine Übergangszeit bereitzustellen, die im Wesentlichen nicht Null ist.

2. Treiberschaltung nach Anspruch 1, wobei der partielle Schaltungsausgangsübergang derart gesteuert ist, dass er im Verhältnis zu anderen Schaltvorgängen in der Schaltung langsam ist.

3. Treiberschaltung nach Anspruch 1 oder 2, ferner umfassend einen Pull-Up-Transistor (Q3) und einen Pull-Down-Transistor (Q1) zum Heraufziehen des Schaltungsausgangs auf einen ersten der zwei Ausgangsspannungspegel, und zum Herabziehen auf einen zweiten der zwei Ausgangsspannungspegel, wobei der partielle Schaltungsausgangsübergang derart gesteuert ist, dass er langsamer ist als das Schalten des Pull-Up- und des Pull-Down-Transistors.

4. Treiberschaltung nach Anspruch 1, 2 oder 3, ferner umfassend einen Mittelpegeltreibertransistor (Q2, Q2N), der beim Einschalten den Schaltungsausgang auf den mittleren Spannungspegel treibt, und beim Ausschalten zulässt, dass der Schaltungsausgang auf einen ersten der zwei Ausgangsspannungspegel getrieben wird, wobei der partielle Schaltungsausgangsübergang derart gesteuert ist, dass er langsamer ist als das Ausschalten des Mittelpegeltreibertransistors.

5. Treiberschaltung nach einem der vorangehenden Ansprüche, wobei die Zeit des partiellen Schaltungsausgangsübergangs einstellbar ist.

6. Treiberschaltung nach einem der vorangehenden Ansprüche, wobei die Zeit des partiellen Schaltungsausgangsübergangs als eine Funktion der Zeit steuerbar ist, die das Leiterausgangssignal benötigt, um einen Leiterausgangsübergang im Wesentlichen abzuschließen.

7. Treiberschaltung nach Anspruch 1, wobei die Steuerungsschaltung umfasst:
Zeitvergleichsschaltkreise zum Vergleichen des Schaltungsausgangssignals und des zweiten Steuersignals, um zu bestimmen, ob das Schaltungsausgangssignal einen Schaltungsausgangsübergang abschließt, bevor das zweite Steuersignal den entsprechenden Steuerungsübergang abschließt; und
Einstellschaltkreise zum Einstellen der Zeit des partiellen Schaltungsübergangs abhängig von dem Vergleich.

8. Treiberschaltung nach Anspruch 1, umfassend Referenzrampenschaltkreise zum Erzeugen einer Referenzrampe, und Vergleichsschaltkreise, die an die Referenzrampenschaltkreise gekoppelt sind, und dazu dienen, einen partiellen Schaltungsausgangsübergang mit der Referenzrampe zu vergleichen.

9. Treiberschaltung nach Anspruch 8, wobei die Vergleichsschaltkreise einen Pegel der partiellen Schaltungsausgangsübergänge mit einer Referenzspannung (V_{REF}) vergleichen, die annähernd in der Mitte zwischen dem mittleren Spannungspegel (V_{HHD}) und einem Ausgangsspannungspegel (V_{DDD}, V_{SSD}) liegt, auf den der Ausgang zu einem Zeitpunkt (t₄) übergeht, der annähernd in der Mitte zwischen einem Beginn (t₃) des partiellen Schaltungsausgangsübergangs und einem erwarteten Abschluss des partiellen Schaltungsausgangsübergangs liegt.

10. Treiberschaltung nach Anspruch 8, wobei die Vergleichsschaltkreise einen integrierenden Einrastvergleicher zum Bereitstellen eines Mittelwertvergleichs zwischen einem partiellen Schaltungsausgangsübergang und einem Signal umfassen, das die Referenzrampe im Wesentlichen über die gesamte Zeit des partiellen Ausgangsübergangs hinweg darstellt.

11. Treiberschaltung nach Anspruch 10, wobei der Vergleicher umfasst:
einen ersten Eingang (V_{DO}) zum Empfangen des partiellen Schaltungsausgangsübergangs;
einen zweiten Eingang (V_{REFRAMP}) zum Empfangen eines Signals, das eine Referenzrampe darstellt; und
ein Paar Ausgangsknoten (Q und QN);
wobei der integrierende Einrastvergleicher nur dann Ladung an den Vergleicherausgangsknoten akkumuliert, wenn das erste oder das zweite Eingangssignal ansteigt.

12. Treiberschaltung nach einem der Ansprüche 8 bis 11, ferner umfassend Einstellschaltkreise zum Einstellen der Zeit des partiellen Schaltungsübergangs abhängig von dem Vergleich.

13. Treiberschaltung nach einem der vorangehenden Ansprüche, wobei die Zeit, die für einen partiellen Schaltungsausgangsübergang benötigt wird, als eine Funktion von Kennlinien von wenigstens einem vorangehenden Schaltungsausgangsübergang steuerbar ist.

14. Treiberschaltung nach Anspruch 13, wobei die Kennlinien anhand der relativen Taktung von zwei Signalen bestimmt werden.

15. Treiberschaltung nach einem der vorangehenden Ansprüche, wobei die Rampensteuerungsschaltung einen Source-Follower zum gesteuerten Treiben des Schaltungsausgangssignals umfasst.

16. Treiberschaltung nach einem der vorangehenden Ansprüche, umfassend einen Schalter (Q2N), der zwischen einer Quelle des mittleren Spannungspegels (V_{HH}) und dem Schaltungsausgangssignal verbunden ist, wobei die Rampensteuerungsschaltung einen Stromspiegel (Q20, Q21) umfasst, der den Schalter mit einem Strom zum gesteuerten Treiben des Schaltungsausgangssignals versorgt.

17. Treiberschaltung nach Anspruch 16, ferner umfassend eine gesteuerte Stromquelle (120) zum Versorgen des Stromspiegels mit einem gesteuerten Strom.

18. Treiberschaltung nach Anspruch 17, wobei der Strom als eine Funktion der Zeit gesteuert wird, die das Leiterausgangssignal benötigt, um einen Leiterausgangsübergang im Wesentlichen abzuschließen.

19. Treiberschaltung nach einem der vorangehenden Ansprüche, die zwischen Quellen unterschiedlicher erster, zweiter und dritter Versorgungsspannungen gekoppelt ist, wobei die zweite Versorgungsspannung (V_{HH}) zwischen der ersten und dritten Versorgungsspannung liegt, wobei die Schaltung umfasst:
Steuerungsschaltkreise, die auf ein Schaltungseingangssignal ansprechen, um ein jeweils unterschiedliches erstes, zweites und drittes Steuersignal zu erzeugen;
einen ersten Schalter (Q3) mit (a) einer ersten Fließelektrode, die an die Quelle der ersten Versorgungsspannung gekoppelt ist, mit (b) einer zweiten Fließelektrode, die an einen Ausgangsknoten gekoppelt ist, von dem ein Schaltungsausgangssignal (V_{DO}) bereitgestellt wird, und mit (c) einer Steuerungselektrode, die auf das erste Steuerungssignal anspricht, um den Stromfluss zwischen den Fließelektroden des ersten Schalters zu steuern;
einen zweiten Schalter (Q1) mit (a) einer ersten Fließelektrode, die an die Quelle der zweiten Versorgungsspannung gekoppelt ist, mit (b) einer zweiten Fließelektrode, die an den Ausgangsknoten gekoppelt ist, und mit (c) einer Steuerungselektrode, die auf das zweite Steuerungssignal anspricht, um den Stromfluss zwischen den Fließelektroden des zweiten Schalters zu steuern;
einen dritten Schalter (Q2) mit (a) einer ersten Fließelektrode, die an die Quelle der dritten Versorgungsspannung gekoppelt ist, mit (b) einer zweiten Fließelektrode, die an den Ausgangsknoten gekoppelt ist, und mit (c) einer Steuerungselektrode, die auf das dritte Steuerungssignal (V_{C2}) anspricht, um den Stromfluss zwischen den Fließelektroden des dritten Schalters zu steuern, wobei das Schaltungsausgangssignal annähernd zwischen der ersten und dritten Versorgungsspannung ansteigende und abfallende Ausgangsübergänge vollzieht, wobei das Schaltungsausgangssignal während jedes Schaltungsausgangsübergangs für eine Nichtnull-Mittelpegelhalteperiode annähernd auf dem zweiten Versorgungsspannungspegel bleibt, wobei die Übergangszeit zwischen der ersten und dritten Versorgungsspannung und/oder zwischen der zweiten und dritten Versorgungsspannung gesteuert wird.

20. Treiberschaltung nach Anspruch 19, wobei das Schaltungsausgangssignal annähernd zwischen der ersten und dritten Versorgungsspannung ansteigende und abfallende Schaltungsausgangsübergänge vollzieht, wobei der dritte Schalter als ein Source-Follower arbeitet, derart, dass der Ausgangsknoten in gesteuerter Weise der Spannung seiner Steuerungselektrode folgt.

21. Treiberschaltung nach Anspruch 19, wobei der dritte Schalter ein N-Kanal-Transistor ist, und wobei ein Kondensator (C_{FB}) vorgesehen ist, um die Anstiegsrate des Stroms zur Steuerungselektrode des dritten Transistors zu prüfen, wenn das Schaltungsausgangssignal von der ersten Spannung auf die dritte Spannung abfällt.

22. Treiberschaltung nach einem der vorangehenden Ansprüche, wobei eine Rampensteuerungsschaltung (118, 119) einen partiellen Schaltungsausgangsübergang als eine Funktion eines stromgespeicherten Steuerwertes steuert, der als Ergebnis eines vorangehenden Schaltungsausgangsübergangs gespeichert wird.

23. Treiberschaltung nach Anspruch 19, wobei:
der erste Schalter ein erster Transistor (Q3) ist;
der zweite Schalter ein zweiter Transistor (Q1) ist;
der dritte Schalter ein dritter Transistor (Q2) ist; und ferner umfassend:
einen vierten und fünften Transistor, die jeweils zwischen der Steuerungselektrode des dritten Transistors und den Quellen des ersten bzw. zweiten Spannungspegels verbunden sind, und Steuerungsschaltkreise zum selektiven Entladen der Steuerungselektrode des dritten Transistors jeweils an den ersten und zweiten Spannungspegel über den vierten bzw. fünften Transistor, derart, dass die Steuerungselektrode des dritten Transistors partielle Übergänge zwischen dem ersten Spannungspegel und dem zweiten Spannungspegel vollzieht.

24. Treiberschaltung nach Anspruch 23, ferner umfassend: Steuerungsschaltkreise zum Bereitstellen des ersten, zweiten und dritten Steuersignals, um das Schaltungsausgangssignal zu veranlassen, während jedes Schaltungsausgangsübergangs für eine Nichtnull-Mittelpegelhalteperiode annähernd auf der mittleren Versorgungsspannung zu bleiben.

25. Treiberschaltung nach Anspruch 23 oder 24, wobei die Steuerungsschaltung Taktsteuerungsschaltkreise zum Steuern der Zeitpunkte des Übergangs des Schaltungsausgangssignals zwischen der ersten oder zweiten Versorgungsspannung und der mittleren Versorgungsspannung umfasst.

26. Treiberschaltung nach Anspruch 24, wobei die Steuerungsspannung Referenzrampenschaltkreise zum Erzeugen einer Referenzrampe sowie Vergleichsschaltkreise umfasst, die an die Referenzrampenschaltkreise gekoppelt sind, und dazu dienen, einen partiellen Schaltungsausgangsübergang mit der Referenzrampe zu vergleichen.

## Revendications

1. Circuit d'attaque électronique servant à générer un signal de sortie de circuit pouvant être appliqué à un conducteur électrique (12) qui génère un signal de sortie du conducteur pouvant être appliqué à une charge (14), les signaux de sortie de circuit et de conducteur mettant respectivement en correspondance des transitions de sortie de circuit et de conducteur de façon approximative entre une paire de niveaux de tension de sortie (V_{DD}, V_{SS}) entre lesquels il existe un niveau de tension intermédiaire (V_{HH}), une inductance et une capacité du conducteur et de la charge produisant une résonance qui permet au signal de sortie de conducteur d'établir quasi totalement chaque transition de sortie de conducteur tandis que le signal de sortie de circuit est maintenu approximativement au niveau de tension intermédiaire pour une période de maintien de niveau intermédiaire non nulle pendant la transition de sortie de circuit correspondante, le circuit comportant un circuit de commande de rampe (118, 119) pour commander des transitions partielles de sortie de circuit entre au moins l'un de la paire des niveaux de tension de sortie et le niveau intermédiaire afin de fournir un temps de transition essentiellement non nul pour une transition partielle de circuit de sortie.

2. Circuit d'attaque selon la revendication 1 dans lequel la transition partielle de sortie de circuit est commandée afin d'être lente par rapport aux autres évènements de commutation dans le circuit.

3. Circuit d'attaque selon la revendication 1 ou 2, comprenant, de plus, un transistor à transition haute (Q3) et un transistor à transition basse (Q1) pour établir la transition haute de la sortie de circuit pour le premier des deux niveaux de tension de sortie et établir une transition basse pour le second des deux niveaux de tension de sortie, dans lequel la transition partielle de sortie de circuit est commandée pour être plus lente que la commutation des transistors à transition haute et à transition basse.

4. Circuit d'attaque selon la revendication 1, 2 ou 3, comprenant, de plus, un transistor de commande du niveau intermédiaire (Q2, Q2N), lequel lors d'une mise sous tension commande la sortie de circuit au niveau de tension intermédiaire et lors d'une mise hors tension permet à la sortie de circuit d'être entraînée à un premier des deux niveaux de tension de sortie, dans lequel la transition de sortie de circuit est commandée pour être plus lente que la mise hors tension du transistor de commande de niveau intermédiaire.

5. Circuit d'attaque selon l'une quelconque des revendications précédentes, dans lequel le temps de la transition partielle de sortie de circuit est réglable.

6. Circuit d'attaque selon l'une quelconque des revendications précédentes, dans lequel le temps de transition partielle de sortie de circuit peut être commandé en fonction du temps pris par le signal de sortie du conducteur pour établir quasi totalement une transition de sortie de conducteur.

7. Circuit d'attaque selon la revendication 1 dans lequel la circuiterie de commande comporte :
une circuiterie de comparaison de temps permettant de comparer le signal de sortie de circuit et le second signal de commande en vue de déterminer si le signal de sortie de circuit établit une transition de sortie de circuit avant que le second signal de commande n'établisse quasi totalement la transition de commande correspondante ; et
une circuiterie de réglage servant à régler le temps de transition de circuit partielle en fonction de la comparaison.

8. Circuit d'attaque selon la revendication 1 comprenant une circuiterie de rampe de référence pour générer une rampe de référence, et une circuiterie de comparateur couplée à la circuiterie de rampe de référence pour comparer une transition partielle de sortie de circuit avec la rampe de référence.

9. Circuit d'attaque selon la revendication 8, dans lequel la circuiterie de comparateur compare un niveau de la transition partielle de sortie de circuit à une tension de référence (V_{REF})qui se trouve approximativement à mi-chemin entre le niveau de tension intermédiaire (V_{HHD}) et un niveau de tension de sortie pour lequel la sortie opère une transition (V_{DDD}, V_{SSD}) à un instant (t₄) se trouvant approximativement à mi-chemin entre un démarrage (t3) de la transition partielle de sortie de circuit et un établissement attendu de la transition partielle de sortie de circuit.

10. Circuit d'attaque selon la revendication 8, dans lequel la circuiterie de comparateur comprend un comparateur intégrateur à verrouillage en vue de fournir une comparaison moyenne entre une transition partielle de sortie de circuit et un signal représentatif de la rampe de référence durant essentiellement la durée entière de la transition partielle de sortie.

11. Circuit d'attaque selon la revendication 10, dans lequel le comparateur comporte:
une première entrée (V_{DO}) pour recevoir la transition partielle de sortie de circuit ;
une seconde entrée (V_{REFRAMP}) pour recevoir un signal représentatif d'une rampe de référence ; et
une paire de noeuds de sortie (Q et QN) ;
dans lequel le comparateur intégrateur à verrouillage accumule la charge sur les noeuds de sortie du comparateur seulement pendant un moment lorsque l'un des premier et second signaux de sortie présente un flanc croissant.

12. Circuit d'attaque selon l'une quelconque des revendications 8 à 11 comprenant, de plus, une circuiterie de réglage pour régler le temps de transition partielle de circuit en fonction de la comparaison.

13. Circuit d'attaque selon l'une quelconque des revendications précédentes, dans lequel le temps occupé pour une transition partielle de circuit est commandé comme une fonction des caractéristiques d'au moins une transition précédente de sortie de circuit.

14. Circuit d'attaque selon la revendication 13, dans lequel lesdites caractéristiques sont déterminées à partir d'une synchronisation relative de deux signaux.

15. Circuit d'attaque selon l'une quelconque des revendications précédentes, dans lequel le circuit de commande de rampe comprend un suiveur de source permettant de commander le signal de sortie de circuit d'une manière contrôlée.

16. Circuit d'attaque selon l'une quelconque des revendications précédentes, comprenant un commutateur (Q2N) connecté entre une source du niveau de tension intermédiaire (V_{HH}) et le signal de sortie de circuit, dans lequel le circuit de commande de rampe comporte un miroir de courant (Q20, Q21) qui fournit un courant au commutateur pour commander le signal de sortie de circuit d'une façon contrôlée.

17. Circuit d'attaque selon la revendication 16, comprenant, de plus, une source de courant contrôlée (120) servant à fournir un courant contrôlé au miroir de courant.

18. Circuit d'attaque selon la revendication 17, dans lequel le courant est contrôlé comme une fonction du temps pris par le signal de sortie de conducteur pour établir quasi totalement une transition de sortie de conducteur.

19. Circuit d'attaque électronique selon l'une quelconque des revendications précédentes, couplé entre des sources de première, deuxième et troisième tensions d'alimentation, la deuxième tension d'alimentation (V_{HH}) se trouvant entre la première et la troisième tensions d'alimentation, le circuit comportant :
une circuiterie de commande répondant à un signal d'entrée de circuit pour générer des premier, deuxième et troisième signaux de commande différents ;
un premier commutateur (Q3) comprenant (a) une première électrode de flux couplée à la source de la première tension d'alimentation, (b) une deuxième électrode de flux couplée à un noeud de sortie à partir duquel un signal de sortie de circuit (V_{DO}) est fourni, et (c) une électrode de commande répondant au premier signal de commande pour commander un flux de courant entre les premières électrodes de flux de commutateur ;
un deuxième commutateur (Q1) comportant (a) une première électrode de flux couplée à la source de la deuxième tension d'alimentation, (b) une deuxième électrode de flux couplée au noeud de sortie, et (c) une électrode de commande répondant au deuxième signal de commande pour commander un flux de courant entre les deuxièmes électrodes de flux de commutateur ; et
un troisième commutateur (Q2) comportant (a) une première électrode de flux couplée à la source de la troisième tension d'alimentation, (b) une seconde électrode de flux couplée au noeud de sortie, et (c) une électrode de commande répondant au troisième signal de commande (V_{C2}) pour commander un flux de courant entre les troisièmes électrodes de flux de commutateur, le signal de sortie de circuit présentant des transitions de sortie de circuit à flanc croissant et décroissant approximativement entre les première et troisième tensions d'alimentation, le signal de sortie de circuit restant approximativement au niveau de la deuxième tension d'alimentation pendant une période de maintien de niveau intermédiaire non nulle au cours de chaque transition de sortie de circuit, le temps de transition entre les première et troisième tensions d'alimentation et/ou entre les deuxième et troisième tensions d'alimentation étant contrôlé.

20. Circuit d'attaque selon la revendication 19, le signal de sortie de circuit présentant des transitions de sortie de circuit croissantes et décroissantes approximativement entre les première et troisième tensions d'alimentation, dans lequel le troisième commutateur agit comme un suiveur de source de telle sorte que le noeud de sortie suit sa tension d'électrode de commande d'une façon contrôlée.

21. Circuit d'attaque selon la revendication 19, dans lequel le troisième commutateur est un transistor à canal N et dans lequel un condensateur (C_{FB}) est fourni pour contrôler la vitesse de montée du courant à l'électrode de commande du troisième transistor lorsque le signal de sortie de circuit chute de la première tension à la troisième tension.

22. Circuit d'attaque selon l'une quelconque des revendications précédentes, dans lequel un circuit de commande de rampe (118, 119) commande une transition partielle de sortie de circuit comme une fonction d'une valeur de commande de courant enregistrée en tant que résultat d'une transition partielle de sortie de circuit précédente.

23. Circuit d'attaque selon la revendication 19 dans lequel le premier commutateur est un premier transistor (Q3); le deuxième commutateur est un deuxième transistor (Q1) ; le troisième commutateur est un troisième transistor (Q2) ; et comprenant, de plus, des quatrième et cinquième transistors connectés entre l'électrode de commande du troisième transistor et les sources des premier et deuxième niveaux de tension, respectivement, et une circuiterie de commande permettant de décharger de façon sélective l'électrode de commande du troisième transistor vers les premier et deuxième niveaux de tension, respectivement, à travers les quatrième et cinquième transistors de telle sorte que l'électrode de commande du troisième transistor produit des transitions partielles entre les premier et deuxième niveaux de tension.

24. Circuit d'attaque selon la revendication 23 comprenant, de plus, une circuiterie de commande pour fournir les premier deuxième et troisième signaux de commande en vue d'entraîner le signal de sortie de circuit à se maintenir approximativement au niveau de la tension d'alimentation intermédiaire pendant une période de maintien de niveau intermédiaire non nulle lors de chaque transition de sortie de circuit.

25. Circuit d'attaque selon la revendication 23 ou 24 dans lequel le circuit de commande comporte une circuiterie de commande de synchronisation en vue de commander les temps de transition du signal de sortie de circuit entre l'une des première et deuxième tensions d'alimentation et la tension d'alimentation intermédiaire.

26. Circuit d'attaque selon la revendication 24, dans lequel le circuit de commande comporte une circuiterie de rampe de référence pour générer une rampe de référence, et une circuiterie de comparateur couplée à la circuiterie de rampe de référence pour comparer une transition partielle de sortie de circuit à la rampe de référence.
